# EUROPÄISCHE PATENTSCHRIFT

(11) **EP 3 616 397 B1**
(45) Veröffentlichungstag und Bekanntmachung des Hinweises auf die Patenterteilung: **12.01.2022**
(21) Anmeldenummer: 18728012.8
(22) Anmeldetag: 26.04.2018
(51) Int. Cl.: H04N 5/225

(54) **VORRICHTUNG ZUR ERFASSUNG VON DATEN**
METHOD FOR CAPTURING DATA
DISPOSITIF D'ACQUISITION DE DONNÉES

(30) Priorität: 27.04.2017 DE 102017004139
(43) Veröffentlichungstag der Anmeldung: 04.03.2020
(73) Patentinhaber: Allied Vision Technologies GmbH, 07646 Stadtroda (DE)
(72) Erfinder: HESTERBERG, Ralf Steffen, 22337 Hamburg (DE); FUNK, Olaf, 21493 Schwarzenbek (DE); FRANCKSEN, Eike, 23611 Bad Schwartau (DE); BUSSE, Erik, 04600 Altenburg (DE)
(74) Vertreter: Klickow & Wetzel PartGmbB
(86) Internationale Anmeldenummer: PCT/DE2018/000129
(87) Internationale Veröffentlichungsnummer: WO 2018/196900

(56) Entgegenhaltungen:
- WO-A1-93/03575
- WO-A1-2005/001942
- GB-A- 2 421 869
- JP-A- 2005 079 408
- US-A1- 2004 218 084
- US-A1- 2007 007 636
- US-B1- 9 521 754

## Beschreibung

Die Erfindung betrifft eine Vorrichtung zur Erfassung von Daten im Sinne einer Digitalkamera und ein Verfahren zur Herstellung einer Vorrichtung zur Erfassung von Daten. Derartige Digitalkameras besitzen in der Regel mindestens einen Bildsensor bzw. Transformationschip, der auftreffende optische Informationen in zugeordnete elektrische Signale transformiert. Bekannt sind beispielsweise Digitalkameras mit sogenannten CCD-Chips.

Eine derartige Digitalkamera besitzt typischerweise ein Kameragehäuse, das ein aus mehreren Linsen bestehendes optisches System trägt. Hinter diesem optischen System ist der Sensor zur Transformation der visuellen Daten in elektrische Daten angeordnet. Zusätzlich besitzt eine derartige Digitalkamera in der Regel Steuerelemente und Speicherelemente. Darüber hinaus ist häufig mindestens eine Schnittstelle zur Kommunikation mit anderen Geräten vorgesehen. Innerhalb der Digitalkamera wird eine Vielzahl von Daten zwischen diversen elektronischen Bauelementen übertragen.

Der grundsätzliche Aufbau einer derartigen Digitalkamera wird beispielsweise in der EP 1432240 A1 beschrieben. Lösungen zur Anordnung des Sensors innerhalb des Kameragehäuses werden in der DE 10 2005 027 892 A1 erläutert.

Für derartige Digitalkameras gibt es eine Vielzahl von Anwendungsgebieten sowohl im privaten als auch im kommerziellen Bereich. In zunehmendem Maße werden entsprechende Digitalkameras auch für Produktionssteuerungen und/oder im Zusammenhang mit Industrierobotern eingesetzt.

In der WO 93/03575 A1 wird bereits eine als Digitalkamera ausgebildete Vorrichtung zur Erfassung von visuellen Daten beschrieben. In einem Kameragehäuse sind hierbei eine Mehrzahl von elektronischen Bauelementen angeordnet und eine Platine ist mit einer Verbindungseinrichtung versehen.

Aus der GB 2 421 869 A ist ebenfalls eine Digitalkamera mit einem Kameragehäuse bekannt, wobei eine Mehrzahl von elektronischen Bauelementen im Kameragehäuse angeordnet sind. Das Gehäuse besteht aus einem Gehäuseunterteil und einem Gehäuseoberteil, die gegeneinander verspannbar sind.

Weitere Digitalkameras werden in der US 2004/218084 A1 sowie der US 9 521 754 B1 beschrieben.

In der JP 2005079408 A wird ein elektronisches Endoskop beschrieben, bei dem ein Platinenstapel verwendet wird, bei dem jeweils elektronische Bauelemente einer Platine in einer Vertiefung einer gegenüberliegenden Platine angeordnet werden. Die Platinen werden relativ zueinander durch eine Dichtmasse abgedichtet.

Die US 2007/007636 A1 beschreibt die Verwendung von Platinenstapeln, wobei in einer Durchgangsausnehmung einer Platine Bauelemente angeordnet werden können. Die Platinen innerhalb des Platinenstapels sind relativ zueinander parallel angeordnet und können durch geeignete Kontakte elektrisch miteinander verbunden werden.

Bei vielen Anwendungen wird eine sehr hohe Qualität der Digitalkameras und der bereitgestellten optischen Informationen gefordert, darüber hinaus sollen entsprechend die Digitalkameras aber auch relativ preiswert und mit einer sehr konstanten hohen Qualität bereitgestellt werden.

Weiterhin werden zunehmend kleinere Kameras nachgefragt, wodurch der verfügbare Bauraum innerhalb eines Kameragehäuses weiter beschränkt ist.

Vorteilhaft für eine kostenseitig optimierte Produktion von Digitalkameras ist es, wenn Komponenten, wie beispielsweise das Gehäuse und optische Bauelemente, für verschiedene Kameratypen verwendbar sind, die sich beispielsweise in dem verwendeten Bildsensor unterscheiden. Jedoch geht mit verschiedenen Bildsensoren in der Regel auch eine unterschiedliche Bauhöhe einher, sodass eine fachgerechte Anordnung des Bildsensors zur Optik der Kamera aufwendig erfolgen muss.

Gemäß dem Stand der Technik ist eine Anschlusseinrichtung einer Schnittstelle zur Kommunikation mit anderen Geräten, beispielsweise in Form eines I/O Steckverbinders, als eine separate elektrische und mechanische Verbindungsvorrichtung ausgebildet. Die elektrische Verbindungsvorrichtung ist in der Regel auf eine Platine aufgelötet, während die mechanische Verbindungsvorrichtung am Kameragehäuse realisiert ist. Um eine korrekte Ausrichtung von mechanischer und elektrischer Verbindungsvorrichtung zueinander zu gewährleisten, muss daher die die elektrische Verbindungsvorrichtung tragende Platine definiert zum Kameragehäuse ausgerichtet sein. Dies erfordert separate Platinen innerhalb der Digitalkamera, da die Sensorplatine andere Ausrichtungsanforderungen aufweist, als die die Verbindungsvorrichtung tragende Platine. Weiterhin erfordert der bekannte Aufbau eine flexible Verbindung zwischen den einzelnen Platinen, die Kosten und ggf. Probleme mit der Signalintegrität verursacht.

Die Kombination der vorstehend genannten Forderungen kann mit den bislang bekannten Verfahren und Vorrichtungen noch nicht erfüllt werden.

Eine Aufgabe der Erfindung ist es daher, eine Ausgestaltung der in einem Kameragehäuse angeordneten Elemente derart zu realisieren, dass der Platzbedarf optimiert wird.

Diese Aufgabe wird erfindungsgemäß durch die Merkmale von Patentanspruch 1 gelöst.

Eine weitere Ausführungsform ist dadurch gekennzeichnet, dass die den Abstand des Bildsensors zur Optik bestimmende Platine/Platinen eine Konturfräsung aufweist/aufweisen, die die Dicke dieser Platine oder die Dicke des Platinenstacks derart verringert, dass in Verbindung mit einem auf der Gehäuseinnenseite der Digitalkamera angeordneten Auflager und einem Klebstoff zwischen der Platine und dem Auflager der Abstand des Bildsensors zur Optik derart anpassbar ist, dass der Bildsensor in einer definierten Ebene bezüglich der Optik anordbar ist.

Eine weitere Ausführungsform ist dadurch gekennzeichnet, dass die kameraseitigen Verbindungseinrichtungen einer Schnittstelle nicht gemäß dem Stand der Technik als elektrische Kontakte angeordnet auf einer Platine und mechanische Verbindungseinrichtungen angeordnet am Gehäuse realisiert sind, sondern gemeinsam auf einer Platine der Digitalkamera angeordnet sind.

Eine weitere Ausführungsform ist dadurch gekennzeichnet, dass die Verbindung der Gehäuseteile mithilfe von mindestens einer Klammer realisiert ist, die durch ihre spezielle Formgestaltung eine Vorspannung aufweist, die eine die Verbindung der Gehäuseteile sichernde Rückstellkraft erzeugt.

Nachfolgend werden eine Mehrzahl von konstruktiven und verfahrenstechnischen Realisierungsmöglichkeiten erläutert, die wahlweise einzeln oder in Kombination miteinander realisiert werden können.

Eine erfindungsgemäße Digitalkamera weist in einer bevorzugten Ausführungsform ein mehrteiliges Kameragehäuse auf. Innerhalb des Kameragehäuses sind mindestens zwei Platinen angeordnet, die zumindest einen Bildsensor und die zugehörigen sowie weitere elektrischen Bauelemente tragen.

Die mindestens zwei Platinen sind miteinander durch Verlötung zu einem Platinenstack verbunden. Eine der Platinen ist dabei vorteilhaft als eine Sensorplatine ausgebildet, die zumindest den Bildsensor trägt, und eine andere Platine ist als eine Hauptplatine ausgebildet, die zumindest einen Haupt-Chip als Steuerelement trägt, der vorteilhaft als ein ASIC, ein FPGA oder ein Prozessor ausgebildet ist.

Mindestens eine der Platinen weist auf ihrer einer anderen Platine zugewandten Seite mindestens eine Vertiefung auf, die, wenn die Platinen zu einem Platinenstack verbunden sind, zwischen den jeweiligen Platinen eine Tasche ausbildet, in der auf der anderen Platine angeordnete Bauelemente einer entsprechenden Höhe aufnehmbar sind. Die mindestens eine Vertiefung ist vorteilhaft als eine Tiefenfräsung realisiert.

Es ist auch an einen Aufbau des Platinenstacks aus drei Platinen gedacht, wobei vorteilhaft eine Platine als eine Sensorplatine, eine Platine als eine Verbindungsplatine und eine Platine als eine Hauptplatine ausgebildet ist. Die Tiefenfräsung zur Ausbildung von Taschen zwischen den Platinen kann in diesem Ausführungsbeispiel ganz oder zumindest teilweise in der Verbindungsplatine angeordnet sein, sodass mit einer kostengünstigeren Anpassung der Verbindungsplatine verschiedene Sensor- und Hauptplatinen miteinander kombinierbar sind. Optional kann sich die Tiefenfräsung zusätzlich in die Sensorplatine erstrecken. Weiterhin sind durch die Verwendung einer Verbindungsplatine bei gleichbleibender Dicke der anderen Platinen Taschen mit größeren Höhen realisierbar, sodass auch Bauelemente mit einer größeren Bauhöhe aufnehmbar sind.

Weiterhin weist eine erfindungsgemäße Digitalkamera in einer vorteilhaften Ausführungsform im Bereich zumindest einer Platine eine Konturfräsung auf, die die Dicke der Platine bzw. die Dicke des Platinenstacks vermindert.

Die Konturfräsung ist besonders vorteilhaft am äußeren Randbereich der Sensorplatine angeordnet, und definiert in Verbindung mit der Dicke der Sensorplatine, der Bauhöhe des Bildsensors, einem innerhalb des Kameragehäuses angeordneten Auflagers für die Sensorplatine bzw. den Platinenstack und der Dicke des Klebstoffs zwischen Auflager und Platinenstack die Position des Bildsensors in der Digitalkamera.

Bei einer erfindungsgemäßen Ausführungsform einer Digitalkamera aufweisend mindestens eine Platine mit mindestens einer Vertiefung zur Aufnahme von auf einer anderen Platine angeordneten Bauelementen und mindestens einer Platine mit mindestens einer Konturfräsung zur Realisierung einer Lageanpassung des Bildsensors in der Digitalkamera, ist eine Realisierung des Platinenstacks aus drei Platinen, ausgebildet als eine Sensorplatine, eine Verbindungsplatine und eine Hauptplatine, besonders vorteilhaft, da die vorstehend genannten Eigenschaften derart realisierbar sind, dass je Platine nur maximal eine Art von Fräsung benötigt wird, wodurch die Fertigungskosten reduzierbar sind.

In einer vorteilhaften Ausführungsform einer erfindungsgemäßen Digitalkamera ist auf dem Platinenstack zur Realisierung mindestens einer Anschlusseinrichtung einer Schnittstelle zur Kommunikation mit anderen Geräten mindestens ein Befestigungselement, beispielsweise ausgebildet als ein sogenannter Fastener, angeordnet.

Ein Fastener ist ein Befestigungselement, das die mechanische Verbindungsvorrichtungen mindestens einer Anschlusseinrichtung mindestens einer Schnittstelle realisiert und das im Bereich der elektrischen Anschlusseinrichtung der mindestens einen Schnittstelle mit der jeweiligen Platine verbunden ist.

Beispielsweise ist die elektrische Anschlusseinrichtung einer Schnittstelle als eine Buchse realisiert, die die elektrischen Steckkontakte aufweist, und der Fastener weist eine zusätzliche Schaub- oder Klemmvorrichtung auf, die die Steckverbindung der Schnittstelle mechanisch sichert.

Ein Fastener kann beispielsweise in einer 90°- oder in einer 180°-Ausführungsform realisiert sein, um eine Anschlusseinrichtung einer Schnittstelle entsprechend seitlich oder hinten am Kameragehäuse anzuordnen. Der Winkel beschreibt dabei die Steckrichtung der Anschlusseinrichtung in Relation zur Stapelrichtung des Platinenstacks.

Weiterhin weist eine erfindungsgemäße Digitalkamera in einer vorteilhaften Ausführungsform zur Verbindung der Teile des Kameragehäuses mindestens eine Klammer auf, die durch ihre Form eine Vorspannung aufweist, die die Verbindung der Teile des Kameragehäuses sichert.

Besonders vorteilhaft ist das Kameragehäuse in zwei Teile gegliedert, die im Bereich ihrer Verbindungsseiten außenliegend eine Struktur aufweisen, die eine Aufnahme für die mindestens eine Klammer bilden.

Die mindestens eine Klammer ist in einer vorteilhaften Ausführungsform aus einem Blech gefertigt und weist in ihrer Längsrichtung eine Wölbung auf, die beispielsweise durch eine oder mehrere Biegungen in Querrichtung der Klammer realisiert ist. Diese Wölbung realisiert eine Vorspannung der Klammer. An den längsseitigen Enden weist die Klammer jeweils eine Befestigungseinrichtung auf, die beispielsweise durch eine bereichsweise Biegung der Klammer realisiert ist. An einem Ende der Klammer realisiert die Biegung in Verbindung mit einer gehäuseseitigen Aufnahmestruktur einen Hinterschnitt und am anderen Ende ein Federelement.

Die Aufnahmestruktur an den Teilen des Kameragehäuses ist vorteilhaft durch jeweils eine an einem Gehäuseteil angeordnete Kante realisiert, die in etwa parallel zu der Verbindungsebene der Gehäuseteile angeordnet sind und hinter denen die Klammer fixierbar ist.

Zur Verbindung der Gehäuseteile ist die mindestens eine Klammer im Bereich der gehäuseseitigen Aufnahmestrukturen positionierbar und durch eine Kraftausübung auf die Wölbung der Klammer in Längsrichtung dehnbar, die gebogenen Enden der Klammer sind dann hinter den zugeordneten Kanten der Gehäuseteile positionierbar. Die aufgrund der Vorspannung der Klammer auftretende Rückstellkraft wirkt in verbindungssichernder Richtung.

Weiterhin betrifft die Erfindung ein Verfahren zur elektrischen Kontaktierung von elektronischen Bauelementen auf mindestens zwei Platinen einer Digitalkamera, bei dem mindestens ein elektronischer Chip auf mindestens einer Platine verlötet wird und bei dem die mindestens zwei Platinen miteinander verlötet werden, dadurch gekennzeichnet, dass der Lötprozess derart durchgeführt wird, dass der mindestens eine elektronische Chip nur einmal durch einen Lötprozess erhitzt wird.

Insbesondere ist bei dem erfindungsgemäßen Verfahren zur Kontaktierung daran gedacht, den mindestens einen temperaturempfindlichen Bildsensor im Lötprozess zu schonen.

In einem ersten Schritt wird daher die Sensorplatine mit Ausnahme des mindestens einen Bildsensors nacheinander auf Ober- und Unterseite bestückt und verlötet. In einem zweiten Schritt wird die Hauptplatine nacheinander auf Ober- und Unterseite und ggf. in einem weiteren Schritt die Verbindungsplatine bestückt und verlötet. Nach dem jeweiligen Bestücken und Verlöten werden die Platinen in platinentypabhängigen Ablagen (Trays) abgelegt. Aus diesen Trays werden die für einen Platinenstack benötigten Platinen entnommen.

Der Platinenstack wird gebildet durch die Entnahme der Hauptplatine aus der zugeordneten Ablage und die Positionierung der Hauptplatine, anschließend die Entnahme der mit der Hauptplatine zu verbindenden Platine, beispielsweise gegeben durch eine Verbindungs- oder eine Sensorplatine, das Aufbringen von Flussmittel auf mindestens einer der zu verbindenden Platinen, das Platzieren der zu verbindenden Platine auf der Hauptplatine, die Wiederholung der vorgenannten Schritte ab der Entnahme der zu verbindenden Platine solange, bis die Sensorplatine auf dem so gebildeten Stapel platziert ist, das anschließende Aufbringen von Flussmittel auf die Sensorplatine und/oder an der Unterseite des Bildsensors und die Platzierung des Bildsensors auf der Sensorplatine und den eigentlichen Lötvorgang, vorteilhaft realisiert als ein Reflow-Zyklus, durch den die einzelnen Platinen des Platinenstacks miteinander verbunden und kontaktiert werden und der Bildsensor mit der Sensorplatine verbunden und kontaktiert wird.

Die erfindungsgemäßen Merkmale erlauben eine Fertigung einer Digitalkamera mit einem besonders kleinen Bauraum dadurch, dass es ermöglicht wird, die gesamte Elektronik der Kamera inklusive der Anschlussvorrichtungen der Kommunikationsschnittstellen auf nur einem Platinenstack zu realisieren, der entsprechend der gegebenen Anforderungen an die Ausrichtung des Bildsensors präzise in der Kamera positionierbar ist.

In den Zeichnungen sind beispielhafte Ausführungsformen der Erfindung schematisch dargestellt. Es zeigen:
- Fig. 1: eine perspektivische Ansicht eines Kameragehäuses,
- Fig. 2: eine vergrößerte ausschnittsweise Darstellung einer erfindungsgemäßen Digitalkamera im Bereich einer Klammer zur Verbindung eines Gehäuseunterteils mit einem Gehäuseoberteil und zur Verspannung dieser Bauelemente relativ zueinander,
- Fig. 3: eine vergrößerte perspektive Darstellung der Klammer gemäß Figur 1,
- Fig. 4: eine vergrößerte und teilweise geschnittene Darstellung eines erfindungsgemäßen Platinenstacks,
- Fig. 5: einen vertikalen Längsschnitt durch innerhalb des Kameragehäuses angeordnete Bauelemente,
- Fig. 6: eine Seitenansicht auf einen erfindungsgemäßen Platinenstack einer Digitalkamera,
- Fig. 7: eine perspektivische Draufsicht auf einen erfindungsgemäßen Platinenstack einer Digitalkamera,
- Fig. 8: einen erfindungsgemäßen Platinenstack einer Digitalkamera mit einem Befestigungselement,
- Fig. 9: einen erfindungsgemäßen Platinenstack einer Digitalkamera mit einer alternativen Ausführungsform des Befestigungselementes,
- Fig. 10: eine weitere Darstellung einer Platinenanordnung innerhalb des Kameragehäuses,
- Fig. 11: die Platinenanordnung gemäß Figur 10 mit einem alternativen Bildsensor,
- Fig. 12: die Platinenanordnung gemäß Figur 10 und Figur 11 mit einer weiteren Alternative als Bildsensor,
- Fig. 13: eine Ansicht einer Platine mit vorgesehenen Lötbereichen und Tiefenfräsungen,
- Fig. 14: ein Ablaufdiagramm zur Veranschaulichung eines Produktionsvorganges für die Hauptplatine,
- Fig. 15: ein Ablaufdiagramm zur Veranschaulichung eines Produktionsvorganges der Sensorplatine und
- Fig. 16: ein weiteres Ablaufdiagramm zur Veranschaulichung eines Produktionsablaufes bei der Herstellung der Gesamtanordnung der Platinen eines erfindungsgemäßen Platinenstacks.

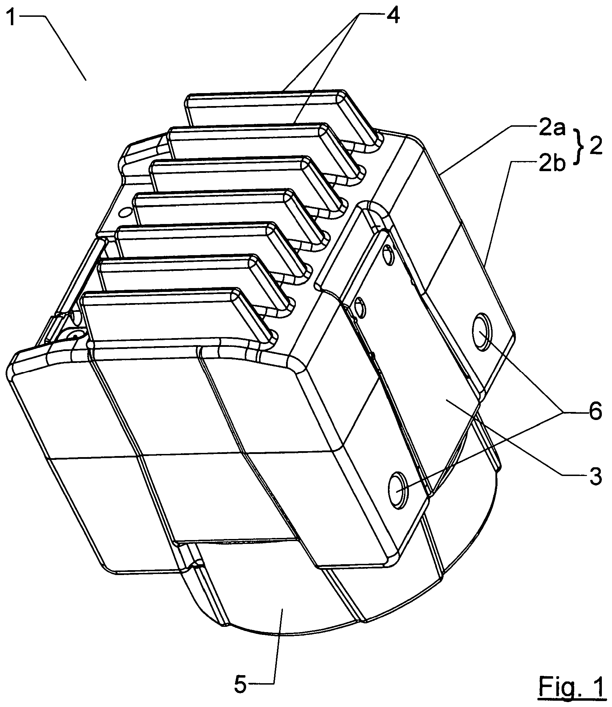

Aus der perspektivischen Darstellung in Figur 1 ist die Grundkonstruktion eines Kameragehäuses (2) einer erfindungsgemäßen Digitalkamera (1) zu erkennen. Das Kameragehäuse (2) besteht aus einem Gehäuseunterteil (2b) und einem Gehäuseoberteil (2a). Das Gehäuseunterteil (2b) und das Gehäuseoberteil (2a) sind mithilfe von zwei Klammern (3) miteinander verbunden. Die Klammern (3) bestehen aus einem elastischen und federnden Material, beispielsweise aus Stahl.

Als Material für die Herstellung des Gehäuseunterteils (2b) und/oder des Gehäuseoberteils (2a) erweist sich insbesondere die Verwendung von Zinkguss als zweckmäßig, da hierdurch feine Strukturen bei relativ dünnen Wandstärken erreicht werden können.

Im Bereich einer Oberseite des Gehäuseoberteiles (2a) sind eine Mehrzahl von Kühlrippen (4) angeordnet, um Wärme an eine Umgebung abgeben zu können. Das Gehäuseunterteil (2b) weist einen als einen umlaufenden Flansch realisierten Objektivhalter (5) auf, der eine Zugangsöffnung zum Gehäuseunterteil (2b) begrenzt. In einem Innenraum des Kameragehäuses (2) sind benachbart zum Objektivhalter (5) optische Bauelemente, beispielsweise eine oder mehrere optische Linsen oder ein Filter angeordnet.

Weiterhin weist das Kameragehäuse (2) im Bereich des Gehäuseunterteils (2b) zwei Montagevorrichtungen (6) auf, die in der dargestellten Ausführungsform als Schraubgewinde realisiert sind und die beispielsweise zur Verbindung der Digitalkamera (1) mit einem Stativ bzw. einer Halterung nutzbar sind.

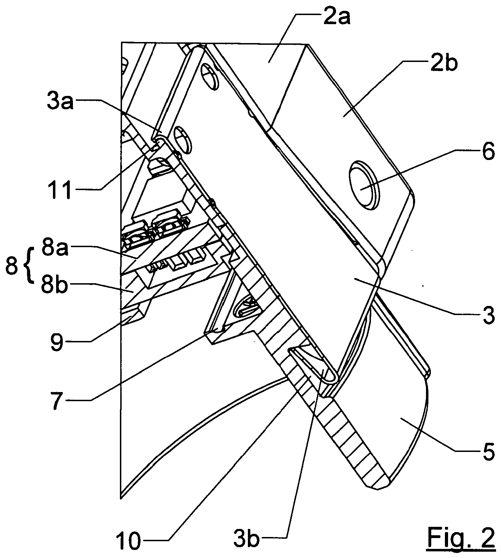

Figur 2 zeigt eine vergrößerte und teilweise geschnittene Darstellung der Digitalkamera (1) im Bereich der montierten Klammer (3).

Im linken Bereich der Figur ist das Gehäuseinnere ausschnittsweise abgebildet. Am unteren Gehäuseteil (2b) kragt auf der Innenseite ein Steg (7) aus, der ein Auflageprofil für einen Filter aufweist. Darüber ist der Platinenstack (8) angeordnet, der in der dargestellten Ausführungsform zwei miteinander verbundene Platinen aufweist, die als eine Hauptplatine (8a) und als eine Sensorplatine (8b) ausgebildet sind. Die Sensorplatine (8b) trägt auf ihrer in der Abbildung untenliegenden Seite einen Bildsensor (9).

In Figur 2 ist weiterhin zu erkennen, dass die Klammer (3) in ihren Endbereichen mit Materialumbiegungen versehen ist. Der in Figur 2 unten rechts dargestellte Umbiegungsbereich (3b) dient für ein erstes Einhängen hinter ein zugeordnetes Profil (10) des Gehäuseunterteiles (2b). Der in Figur 2 oben links an der Klammer (3) zu erkennende weitere Umbiegungsbereich (3a) dient zu einem Einclippen in ein Gegenprofil (11) des Gehäuseoberteiles (2a).

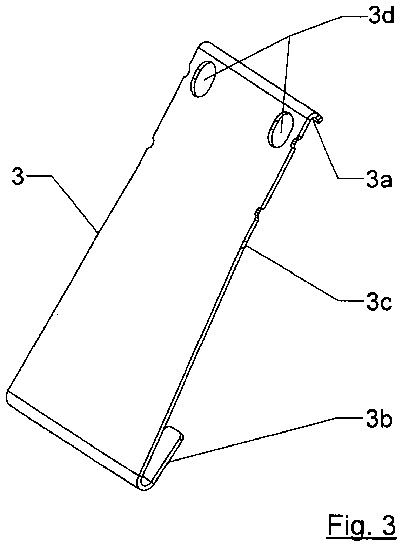

Die perspektivische Darstellung in Figur 3 zeigt den Aufbau der Klammer (3), die in Richtung ihrer Längserstreckung eine leicht angewinkelten Umbiegung (3c) aufweist. In einem montierten Zustand verläuft die Umbiegung (3c) etwa in einem Bereich des Überganges vom Gehäuseunterteil (2b) zum Gehäuseoberteil (2a). Die Umbiegung (3c) unterstützt eine elastische Längung der Klammer (3) bei einem Einclippen.

Der dem Gehäuseoberteil (2a) zugeordnete Umbiegungsbereich (3a) bildet mit dem Gegenprofil (11) des Gehäuseoberteils (2a) in einem montierten Zustand einen Hinterschnitt. Der dem Gehäuseunterteil (2b) zugeordnete Umbiegungsbereich (3b) ist als ein zweigeteiltes Federelement ausgebildet. Die Zweiteilung ermöglicht eine Anpassung an die runde Außenkontur des Objektivträgers (5) im Bereich des Profils (10).

Weiterhin weist die Klammer (3) zwei Montagehilfen (3d) auf, die als Aussparungen in der Klammer (3) realisiert sind.

Durch die Verwendung der Klammer (3) werden Verklebungen oder Verschraubungen am Gehäuse (2) vermieden. Der Montagevorgang ist darüber hinaus mit sehr geringem Zeitaufwand durchführbar.

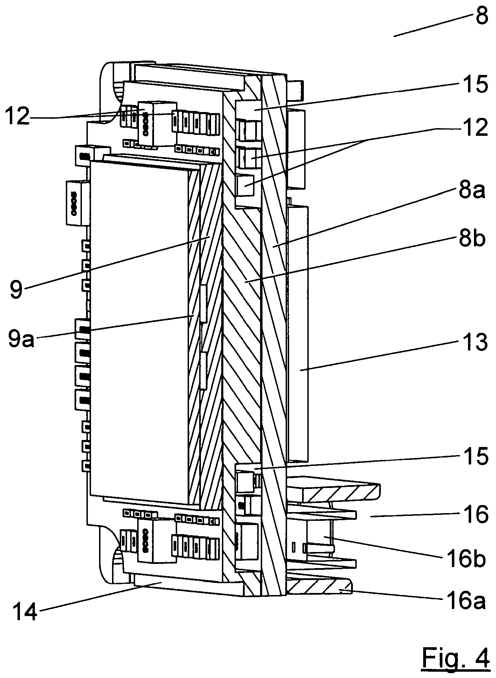

Figur 4 zeigt einen Querschnitt des Platinenstacks (8). Der Platinenstack (8) weist zwei Platinen auf, die als eine Hauptplatine (8a) und als eine Sensorplatine (8b) ausgebildet sind.

Neben dem Bildsensor (9), der ein Sensorglas (9a) aufweist, sind sowohl auf der Sensorplatine (8b) als auch auf der Hauptplatine (8a) elektronische Bauelemente (12) angeordnet, die beispielsweise als Kondensatoren, Widerstände, Dioden und/oder ICs ausgebildet sein können.

Die Hauptplatine (8a) trägt zudem das als ein Haupt-Chip (13) ausgebildete Steuerelement der Digitalkamera (1), der in dem gezeigten Beispiel als ein ASIC realisiert ist.

Die Sensorplatine (8b) weist an ihren in der Figur 4 oben- und untenliegenden Seiten eine Konturfräsung (14) auf, über die die Position des Bildsensors (9) in der Digitalkamera (1) beeinflussbar ist. Weiterhin weist die Sensorplatine (8b) zwei Vertiefungen (15) auf, die als Tiefenfräsungen realisiert sind und die Taschen zwischen der Hauptplatine (8a) und der Sensorplatine (8b) ausbilden, die der Aufnahme von Bauelementen (12) zwischen den Platinen dienen.

Durch eine Metallisierung im Bereich der die Vertiefungen (15) begrenzenden Flächen der Platinen kann eine elektromagnetische Abschirmung der innerhalb einer so ausgebildeten Tasche aufgenommenen Bauelemente (12) erreicht werden.

Neben dem Haupt-Chip (13) ist auf der Hauptplatine (8a) eine Anschlussvorrichtung einer Schnittstelle (16) angeordnet, die ein Befestigungselement (16a) und einen I/O-Steckverbinder (16b) aufweist.

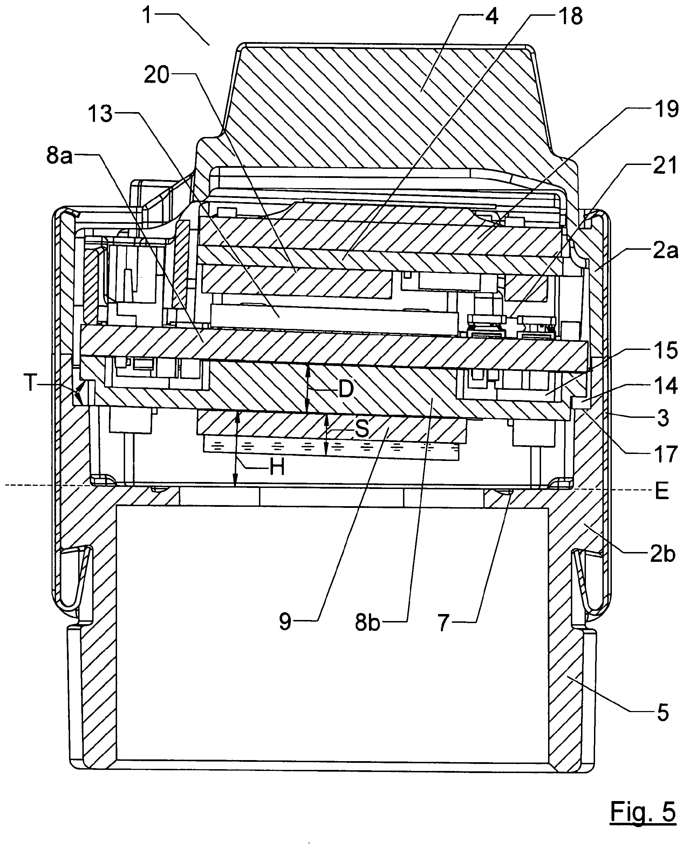

Figur 5 veranschaulicht in einer Querschnittdarstellung der Digitalkamera (1) die Verwendung von Konturfräsungen (14) im Bereich von Platinen, um hierdurch einen Höhenausgleich durchführen zu können. Zu erkennen ist zunächst auch in dieser Querschnittdarstellung die Verwendung der Klammern (3) zur Verbindung des Gehäuseunterteils (2b) und des Gehäuseoberteils (2a). Die Dicke (S) des Bildsensors (9) ist für verschiedene Bildsensoren (9), die in einer erfindungsgemäßen Digitalkamera (1) einsetzbar sind, variabel aber in jedem individuellen Fall gegeben. Unter der erfindungsgemäßen Verwendung einer Konturfräsung (14) der Tiefe (T) ist es möglich, einen Höhenausgleich derart zu realisieren, dass die Höhe (H), die die Position des Bildsensors (9) zu einer fixen Referenzebene (E) der Digitalkamera (1) definiert, entsprechend der Systemanforderungen anpassbar ist.

Eine Grobanpassung kann dabei durch die Auswahl der Sensorplatine (8b) erfolgen, die eine der Auswahl entsprechende Dicke (D) aufweist. Eine weitere Anpassung der Höhe (H) kann durch den bei der Montage des Platinenstacks (8) im Kameragehäuse (2) eingesetzten Klebstoff erfolgen. Dabei wird der Klebstoff auf ein zugeordnetes Auflager (17) im Gehäuseinnenraum und/oder die Sensorplatine (8b) im Bereich der Konturfräsung (14) aufgebracht und die Sensorplatine (8b) im Kameragehäuse (2) ausgerichtet. Der Klebstoff wird anschließend gehärtet und verbindet die Sensorplatine (8a) im Bereich des Auflagers (17) mit dem Kameragehäuse (2). Diese Möglichkeit ist jedoch durch das Schrumpfen des Klebstoffes beim Aushärten und eine temperaturabhängige Ausdehnung des Klebstoffes nach dem Aushärten nur in einem sehr begrenzten Bereich möglich.

Weiterhin ist in Figur 5 die Verwendung einer Erweiterungsplatine (18) dargestellt, die einen zusätzlichen elektronischen Chip (19), beispielsweise ausgebildet als ein FPGA, und ein Speicherelement (20), beispielsweise in Form von mindestens einem RAM-Baustein, trägt und die über Verbindungsstecker (21) mit der Hauptplatine (8a) verbindbar ist.

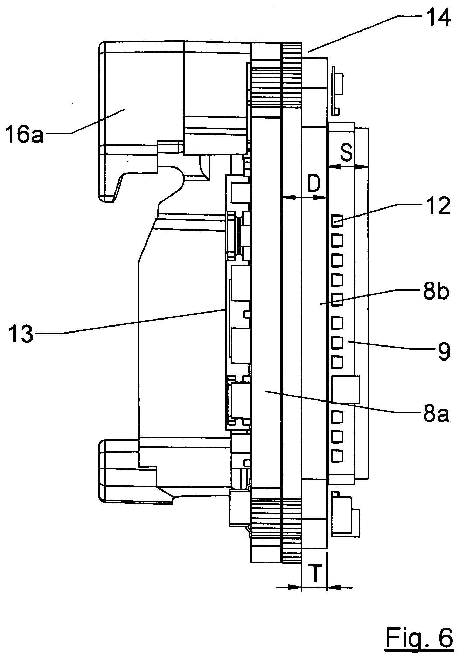

Figur 6 veranschaulicht ergänzend zu Figur 5 nochmals die Anordnung der Dicke (D) der Sensorplatine (8b) und der Dicke (S) des Bildsensors (9) sowie der Tiefe (T) der Konturfräsung (14). Dargestellt ist eine Seitenansicht auf einen erfindungsgemäßen Platinenstack (8), aufweisend eine Hauptplatine (8a) sowie eine Sensorplatine (8b).

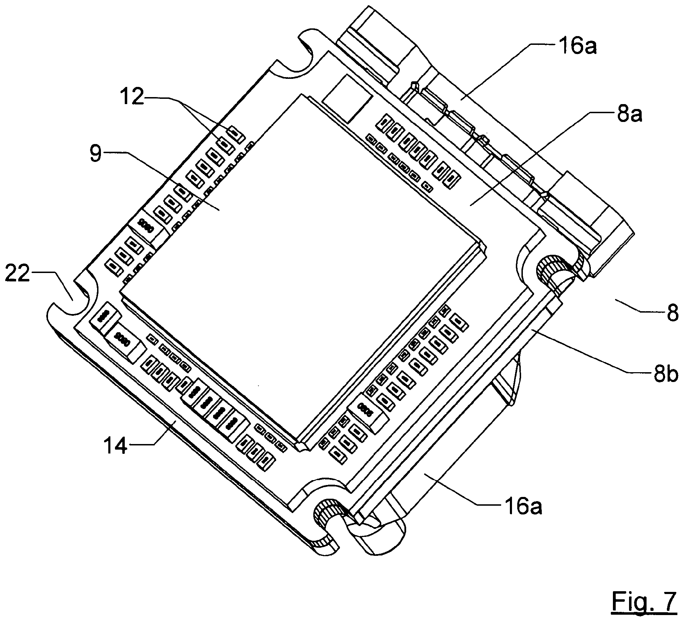

Figur 7 veranschaulicht in einer perspektivischen Darstellung die Anordnung eines Bildsensors (9) auf einer Sensorplatine (8b) eines erfindungsgemäßen Platinenstacks (8) einer Digitalkamera (1). Darüber hinaus ist eine Vielzahl von elektronischen Bauelementen (12) zu erkennen, die auf der Sensorplatine (8b) angeordnet sind. Im Bereich der Hauptplatine (8a) ist ein Befestigungselement (16a) angeordnet, mit dem die mechanische Sicherung von zwei Anschlussvorrichtungen von zwei Schnittstellen (16) realisierbar ist.

Auch eine zweiteilige oder mehrteilige Ausführung des Befestigungselementes (16a) mit einer Zuordnung eines Teils zu jeweils mindestens einer Schnittstelle (16) ist realisierbar.

Als zugeordnete elektronische Bauelemente (12) können beispielsweise ein Flash-Speicher, ein Abblockkondensator, ein Spannungsregler, eine Stromversorgung, ein Taktgenerator und/oder eine Schutzbeschaltung verwendet werden. Die entsprechenden Bauelemente können auch in mehrfacher Ausführungsform verwendet sein.

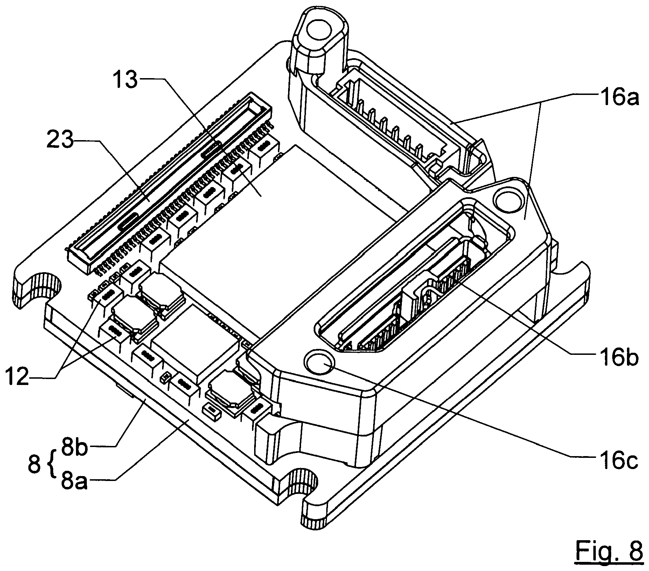

Gemäß der Abbildung in Figur 8 sind auf der Hauptplatine (8a) des Platinenstacks (8) neben dem Haupt-Chip (13) und den weiteren elektronischen Bauelementen (12) ein Steckverbinder (23) und zwei externe Verbindungsvorrichtungen (16) mit einem Befestigungselement (16a) angeordnet.

Der Steckverbinder (23) dient als Verbindungsmöglichkeit für eine optionale Erweiterungsplatine (18), wie in Figur 5 dargestellt.

Die Verbindungsvorrichtungen der Schnittstellen (16) weisen in der dargestellten vorteilhaften Ausführungsform jeweils eine elektrische Verbindungseinrichtung (16b) auf, die den eigentlichen Buchsenkontakt realisiert und die zumindest mit der Hauptplatine (8a) elektrisch verbunden ist. Eine solche Buchse kann beispielsweise eine USB-, eine CSI-2- oder eine I/O-Schnittstelle realisieren. Das zugeordnete Befestigungselement (16a) ist im Bereich einer elektrischen Verbindungseinrichtung (16b) angeordnet und beispielsweise durch eine Verlötung und/oder eine mechanische Verbindung an der Hauptplatine (8b) und/oder dem Platinenstack (8) befestigt.

Ein Befestigungselement (16a) ist vorteilhaft aus einem festen Material, beispielsweise aus Zinkguss, gefertigt und weist mindestens eine mechanische Verbindungseinrichtung (16c) auf, die beispielsweise als ein Schraubgewinde ausgebildet ist. Das in Figur 8 dargestellte einteilige Befestigungselement (16a) ist in einer 90°-Ausrichtung zur Hauptplatine (8a) angeordnet.

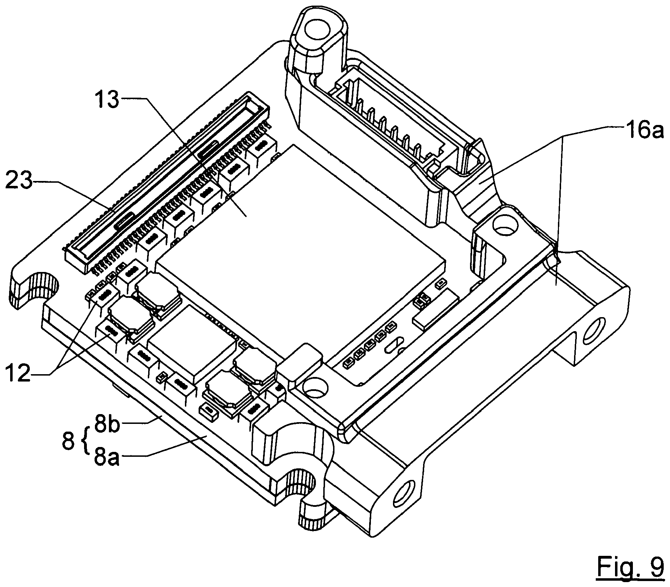

Gemäß der Darstellung in Figur 9 ist eine Ausführungsform des Platinenstacks (8) einer Digitalkamera (1) aufweisend ein einteiliges Befestigungselement (16a) in einer bereichsweisen 90°-Ausrichtung und einer bereichsweisen 180°-Ausrichtung.

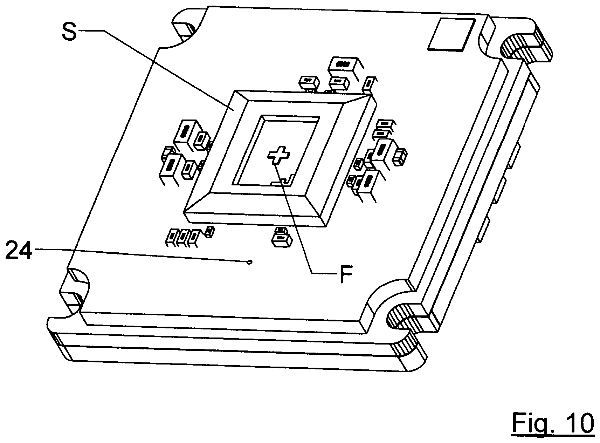

Figur 10 veranschaulicht in einer perspektivischen Darstellung nochmals die Anordnung einer Konturfräsung (14) der Tiefe (T) im Bereich der Sensorplatine (8b) sowie die Anordnung eines kleinen Bildsensors (9) auf der Sensorplatine (8b). Der Bildsensor (9) besitzt eine aktive Fläche (F). Die Dicke (D) der verwendeten Sensorplatine (8b) wird üblicherweise erfindungsgemäß an den verwendeten Bildsensor (9) angepasst. Eine Abdeckung des Bildsensors (9) erfolgt üblicherweise mit einer Glasplatte (nicht dargestellt).

Durch die Integration von elektronischen Bauelementen (12) zwischen den Platinen eines Platinenstacks (8) ist es möglich, eine Digitalkamera (1) mit einer sehr kompakten Bauform zu realisieren. Insbesondere ist es möglich, durch die gute Anbindung der Hauptplatine (8a) und der Sensorplatine (8b) gegebenenfalls erforderliche Abblockkondensatoren zu minimieren. Es kann insbesondere ein direktes Löten der Platinen zur Vermeidung von Steckverbindern durchgeführt werden. Die exakte Positionierung der Platinen übereinander erfolgt beim Verlöten dabei automatisch aufgrund der Oberflächenspannung des flüssigen Lötzinns, das die entsprechenden Lötpads auf den Platinen verbindet.

Bei einer Realisierung von Hochgeschwindigkeitsdatenverbindungen kann zudem eine sehr gute Signalintegrität erreicht werden.

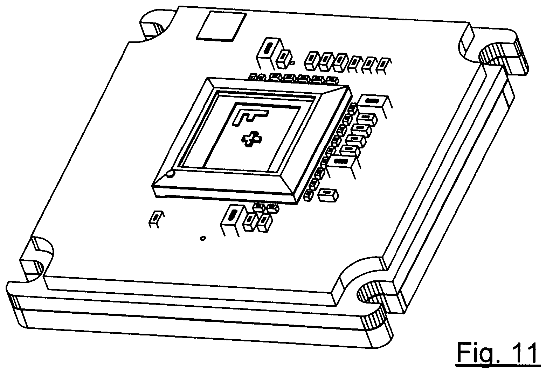

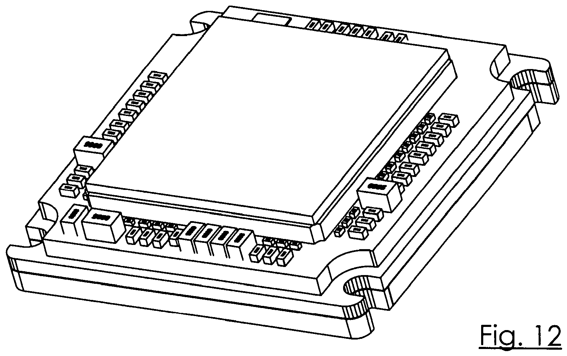

Figur 11 und Figur 12 zeigen die Platinenanordnung jeweils mit Bildsensoren (9) in verschiedenen Dimensionierungen.

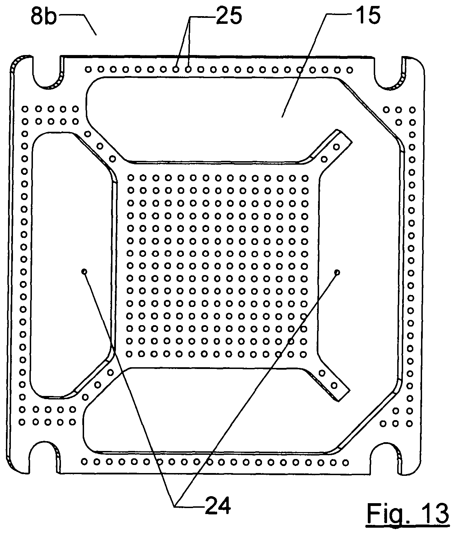

Figur 13 zeigt eine Ansicht der Unterseite einer erfindungsgemäß ausgebildeten Sensorplatine (8b). Die Sensorplatine (8b) weist zwei Vertiefungen (15) auf, die zwei Taschen zur Aufnahme von auf einer anderen Platine angeordneten Bauelementen (12) ausbilden. Eine der Taschen ist dabei in drei Untertaschen gegliedert. Im Bereich der nicht gefrästen Struktur weist die Sensorplatine (8b) eine Vielzahl von Lötpads (25) auf, die der Kontaktierung der zu verbindenden Platine dienen.

Weiterhin sind im Bereich der Vertiefungen (15) zwei Löcher angeordnet, die als Belüftungskanäle für den zwischen Platinenstack (8), Kameragehäuse (2) und Filter bzw. Abdeckglas begrenzten Raum dienen und einen Druckausgleich ermöglichen. Ohne die Möglichkeit eines Druckausgleiches ist bei veränderlichem Umgebungsdruck ansonsten ein Beschlagen der Optik von innen möglich. Die zwischen den Platinen des Platinenstacks (8) durch die Lötverbindungen gebildete Struktur wirkt dabei als ein Filter im Sinne eines Labyrinthes für einströmende Luft und verhindert somit das Einbringen von Fremdkörpern, wie beispielsweise Staub, in den Bereich des Bildsensors (9).

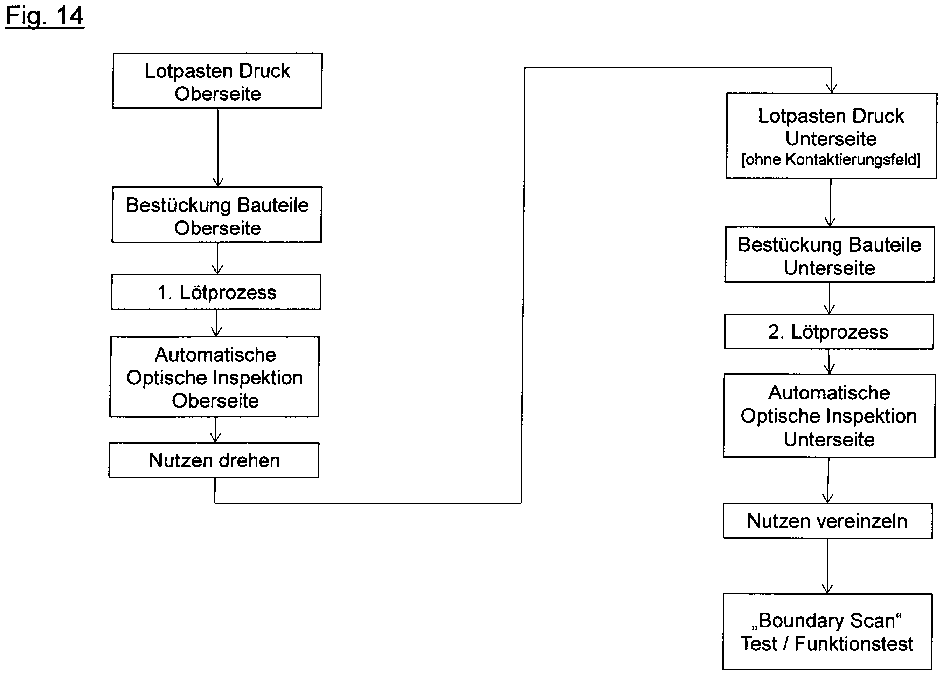

Das Ablaufdiagramm in Figur 14 veranschaulicht den Herstellungsprozess für die Hauptplatine. In einem ersten Prozessschritt wird auf die Oberseite der Platine eine Lötpaste aufgetragen. Vorzugsweise ist diese bleifrei. Ebenfalls bevorzugt erfolgt das Auftragen in einem Druckprozess, ähnlich zu einem Siebdruck unter Verwendung einer Schablone. Die Dicke der Schablone bestimmt dabei die Menge der aufgetragenen Lötpaste.

Nach einer Positionierung der vorgesehenen Komponenten auf der Oberseite der Hauptplatine (Bestückung) wird ein erster Aufschmelzprozess durchgeführt (1. Lötprozess). Danach erfolgt eine automatisierte optische Inspektion der Oberseite. Nach einer Drehung der Platine wird Lötpaste auf die Unterseite der Hauptplatine aufgetragen und danach werden die vorgesehenen Komponenten im Bereich der Unterseite positioniert. Anschließend wird wiederum ein Aufschmelzprozess (2. Lötprozess) durchgeführt und erneut erfolgt eine automatisierte optische Inspektion der Unterseite. Nach der Durchführung der optischen Inspektion erfolgt eine Trennung der einzelnen Platinen und die voneinander separierten Platinen werden in zugeordnete Trays eingesetzt. Anschließend wird ein Test hinsichtlich der erreichten Verbindungen und abschließend ein Funktionstest durchgeführt.

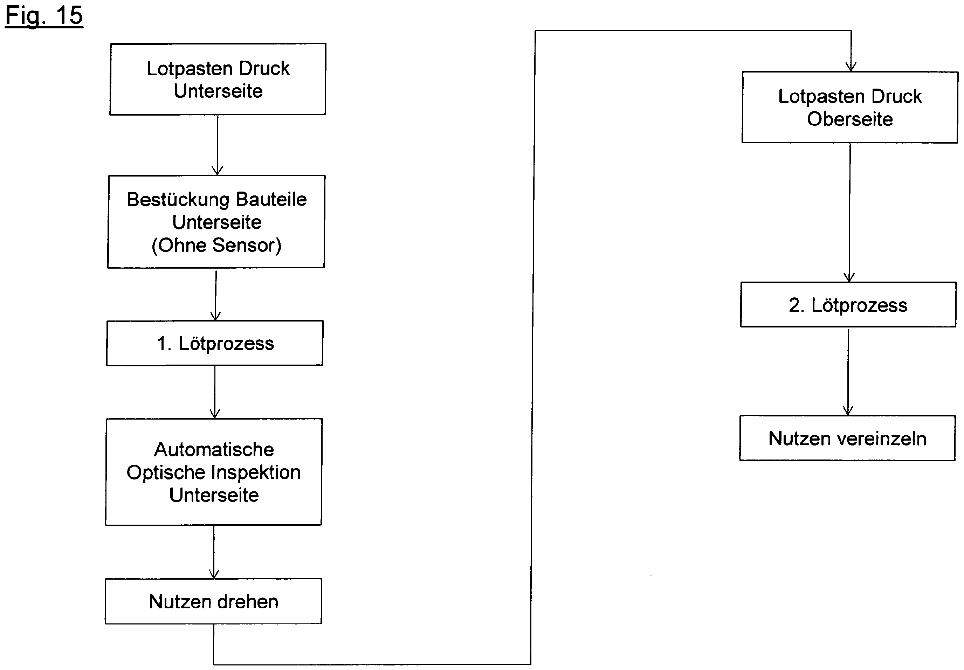

Figur 15 veranschaulicht den Fertigungsprozess für die Sensorplatine. Hier wird zunächst die Lötpaste auf die Unterseite der Sensorplatine aufgetragen und ein erster Aufschmelzprozess durchgeführt. Anschließend erfolgt auch in diesem Fall eine Drehung der Platine und die Lötpaste wird auf die Oberseite der Sensorplatine aufgetragen. Danach werden die vorgesehenen elektronischen Bauteile auf der Unterseite positioniert. Der Sensor wird noch nicht positioniert. Es wird dann der Aufschmelzprozess durchgeführt und auch in diesem Fall erfolgt abschließend eine automatisierte optische Inspektion der Unterseite. Danach werden die Platinen voneinander getrennt und voneinander getrennt in Trays angeordnet. Die Lötpaste enthält in der Regel Lötzinn und ein Flussmittel.

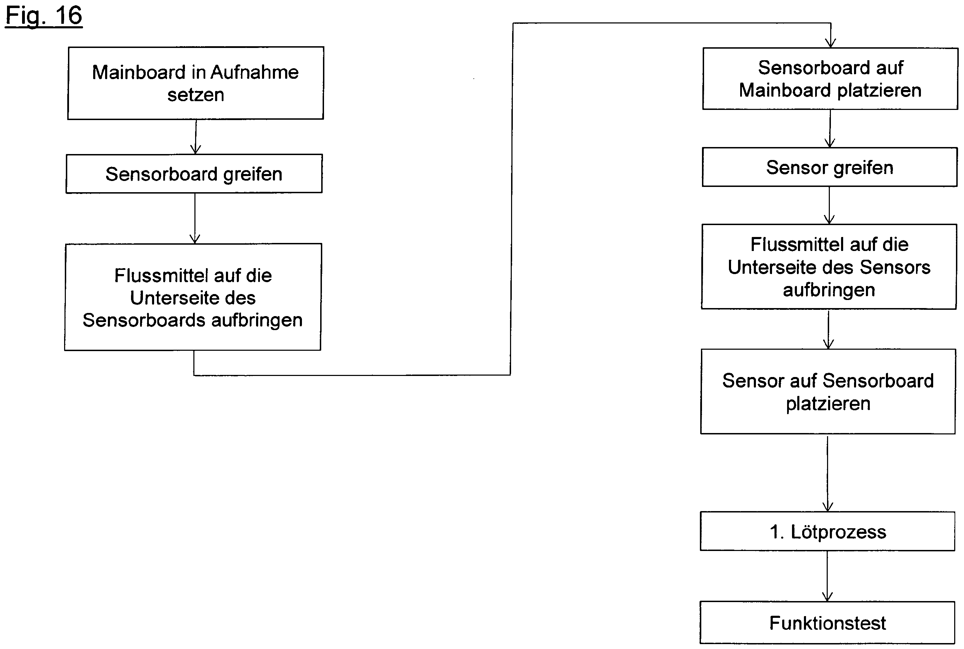

Figur 16 veranschaulicht den Fertigungsprozess für die Kombination der Platinen. Ein zunächst leeres Tray wird hierbei mit der Hauptplatine (Mainboard) versehen und es wird dann die Sensorplatine hinzugefügt. Dann wird auf die Unterseite der Sensorplatine die Lötpaste aufgetragen. In einem weiteren Fertigungsschritt wird die Sensorplatine auf der Hauptplatine positioniert und der Sensor wird hinzugefügt. Dann wird das Flussmittel auf der Unterseite des Sensors angeordnet und der Sensor wird auf der Sensorplatine positioniert. Danach erfolgt ein Aufschmelzprozess für den Sensor und abschließend ein Funktionstest.

Durch das in den Figuren 14 bis 16 veranschaulichte Verfahren wird erreicht, dass beim Bestücken der Platinen mit CMOS-Bildsensoren die betreffenden Bildsensoren den Lötprozess nur einmal durchlaufen.

Zum einen erfolgt erfindungsgemäß eine Integration von elektronischen Bauelementen in Vertiefungen innerhalb des Platinenstacks, um hierdurch eine kompakte konstruktive Realisierung zu unterstützen.

Darüber hinaus erfolgt ein Höhenausgleich insbesondere in Bezug auf den Bildsensor durch mindestens eine Konturfräsung im Bereich mindestens einer Platine.

Gemäß einer weiteren Variante erfolgt eine Integration der mechanischen Sicherung von Anschlussvorrichtungen von Schnittstellen in ein oder mehrere mit dem Platinenstack verbundene Befestigungselemente und gemäß einer weiteren Variante wird ein spezieller Lötprozess zur Vermeidung einer Beschädigung von elektronischen Bauelementen durch den Lötprozess durchgeführt.

Schließlich werden Gehäuseteile durch die Verwendung von mindestens einer speziellen federnden Klammer miteinander verbunden, um sowohl eine zuverlässige Verbindung der Gehäusekomponenten als auch einen einfachen Produktionsablauf zu ermöglichen.

Hinsichtlich der internen Datenkommunikation wird bevorzugt ein entsprechender Datenbus eingesetzt. Die Definition der einzelnen Kamerafunktionen sowie die vorgesehene Koordinierung der Funktionen werden bevorzugt über einen als ein ASIC ausgebildeten Haupt-Chip realisiert.

## Patentansprüche

1. Vorrichtung zur Erfassung von visuellen Daten, die als eine Digitalkamera (1) ausgebildet ist, die in einem Kameragehäuse (2) eine Mehrzahl von elektronischen Bauelementen (12) aufweist, sowie bei der innerhalb des Kameragehäuses (2) mindestens zwei Platinen übereinander angeordnet und zu einem Platinenstack (8) verbunden sind und wobei mindestens eine der Platinen im Bereich ihrer einer anderen der Platinen zugewandten Seite mindestens eine Vertiefung (15) zur Aufnahme von auf einer anderen Platine angeordneten elektronischen Bauelementen (12) aufweist, wobei die mindestens eine Vertiefung (15) im Bereich mindestens einer Platine zur Aufnahme von elektronischen Bauelementen (12), als mindestens eine Tiefenfräsung realisiert ist, **dadurch gekennzeichnet, dass** die Platinen im Platinenstack (8) miteinander verlötet sind und dass mindestens eine Platine mit einer Konturfräsung (14) einer Tiefe (T) zur Realisierung eines Höhenausgleiches versehen ist.

2. Vorrichtung nach mindestens einem der vorstehenden Ansprüche, **dadurch gekennzeichnet, dass** der Platinenstack (8) aus drei Platinen realisiert ist, von denen eine Platine als eine Verbindungsplatine (8c) ausgebildet ist, wobei sich die Vertiefung (15) zur Aufnahme von elektronischen Bauelementen (12) zumindest im Bereich der Verbindungsplatine (8c) erstreckt.

3. Vorrichtung nach Anspruch 1, **dadurch gekennzeichnet, dass** durch den Höhenausgleich insbesondere eine exakte Positionierung eines auf einer Sensorplatine (8b) angeordneten Bildsensors (9) im optischen System der Digitalkamera (1) in Abhängigkeit der Dicke (D) der den Bildsensor (9) tragenden Platine und der Höhe (S) des Bildsensors (9) realisierbar ist.

4. Vorrichtung nach Anspruch 1, **dadurch gekennzeichnet, dass** mindestens eine mechanische Verbindungseinrichtung (16c) in mindestens ein auf einer Platine angeordnetes Befestigungselement (16a) integriert ist.

5. Vorrichtung nach Anspruch 4, **dadurch gekennzeichnet, dass** das mindestens eine Befestigungselement (16a) im Bereich von jeweils einer Anschlussvorrichtung einer Schnittstelle (16) angeordnet ist und eine mechanische Sicherung einer elektrischen Verbindung realisiert.

6. Vorrichtung nach Anspruch 5, **dadurch gekennzeichnet, dass** die Anschlussvorrichtung einer Schnittstelle (16) als eine USB-Anschlussvorrichtung, eine CSI-2-Anschlussvorrichtung und/oder eine I/O-Anschlussvorrichtung realisiert ist.

7. Vorrichtung nach Anspruch 1, **dadurch gekennzeichnet, dass** ein Gehäuseunterteil (2b) mithilfe mindestens einer federnden Klammer (3) mit einem Gehäuseoberteil (2a) verspannt ist.

## Claims

1. Device for capturing visual data, said device being embodied as a digital camera (1) that comprises a plurality of electronic components (12) in a camera housing (2), and in which at least two circuit boards are arranged one above the other within the camera housing (2) and are connected so as to form a circuit board stack (8), and wherein at least one of the circuit boards comprises in the region of its side that is facing another of the circuit boards at least one depression (15) for receiving electronic components (12) that are arranged on another circuit board, wherein the at least one depression (15) is realized as at least one depth-milled depression in the region of at least one circuit board so as to receive electronic components (12), **characterized in that** the circuit boards in the circuit board stack (8) are soldered to one another, and **in that** at least one circuit board is provided with an outline milling (14) of a depth (T) so as to realize a compensation for height.

2. Device according to at least one of the preceding claims, **characterized in that** the circuit board stack (8) is realized from three circuit boards of which one circuit board is embodied as a connecting circuit board (8c), wherein the depression (15) for receiving electronic components (12) extends at least in the region of the connecting circuit board (8c).

3. Device according to Claim 1, **characterized in that** it is possible by means of the compensation for height to realize in particular an exact positioning of an image sensor (9) that is arranged on a sensor circuit board (8b) in the optical system of the digital camera (1) in dependence upon the thickness (D) of the circuit board that supports the image sensor (9) and upon the height (S) of the image sensor (9).

4. Device according to Claim 1, **characterized in that** at least one mechanical connecting device (16c) is integrated into at least one fastening element (16a) that is arranged on a circuit board.

5. Device according to Claim 4, **characterized in that** the at least one fastening element (16a) is arranged in the region of respectively a connecting device of an interface (16) and said fastening element realizes a mechanical securing arrangement of an electrical connection.

6. Device according to Claim 5, **characterized in that** the connecting device of an interface (16) is realized as a USB connecting device, a CSI-2 connecting device and/or an I/O connecting device.

7. Device according to Claim 1, **characterized in that** a housing lower part (2b) is clamped to a housing upper part (2a) with the aid of at least one resilient clamp (3).

## Revendications

1. Dispositif d'acquisition de données visuelles, qui est réalisé sous la forme d'une caméra numérique (1) qui présente dans un boîtier de caméra (2) une pluralité de composants électroniques (12), et dans lequel, à l'intérieur du boîtier de caméra (2), au moins deux platines sont disposées l'une au-dessus de l'autre et reliées en une pile de platines (8), et au moins l'une des platines présentant au niveau de sa face tournée vers une autre des platines au moins un creux (15) destiné à recevoir des composants électroniques (12) disposés sur une autre platine, ledit au moins un creux (15) étant réalisé au niveau d'au moins une platine destinée à recevoir des composants électroniques (12) sous la forme d'au moins un fraisage en profondeur,
**caractérisé en ce que** les platines dans la pile de platines (8) sont reliées les unes aux autres par brasage, et **en ce qu'**au moins une platine est dotée d'un détourage (14) d'une profondeur (T) afin de réaliser une compensation de hauteur.

2. Dispositif selon au moins l'une des revendications précédentes, **caractérisé en ce que** la pile de platines (8) est réalisée à partir de trois platines dont une platine est réalisée sous la forme d'une platine de liaison (8c), le creux (15) destiné à recevoir des composants électroniques (12) s'étendant au moins au niveau de la platine de liaison (8c).

3. Dispositif selon la revendication 1, **caractérisé en ce que** la compensation de hauteur permet de réaliser en particulier un positionnement exact d'un capteur d'image (9) disposé sur une platine de capteur (8b) dans le système optique de la caméra numérique (1) en fonction de l'épaisseur (D) de la platine portant le capteur d'image (9) et de la hauteur (S) du capteur d'image (9).

4. Dispositif selon la revendication 1, **caractérisé en ce qu'**au moins un dispositif de liaison mécanique (16c) est intégré dans au moins un élément de fixation (16a) disposé sur une platine.

5. Dispositif selon la revendication 4, **caractérisé en ce que** ledit au moins un élément de fixation (16a) est disposé au niveau de respectivement un dispositif de connexion d'une interface (16) et réalise une protection mécanique d'une liaison électrique.

6. Dispositif selon la revendication 5, **caractérisé en ce que** le dispositif de connexion d'une interface (16) est réalisé sous la forme d'un dispositif de connexion USB, d'un dispositif de connexion CSI-2 et/ou d'un dispositif de connexion d'E/S.

7. Dispositif selon la revendication 1, **caractérisé en ce qu'**une partie inférieure de boîtier (2b) est serrée à l'aide d'au moins une pince élastique (3) avec une partie supérieure de boîtier (2a).
